# DEMANDE DE BREVET EUROPEEN

(11) **EP 3 979 337 A1**
(43) Date de publication de la demande: **06.04.2022**
(21) Numéro de dépôt: 21196473.9
(22) Date de dépôt: 14.09.2021
(51) Int. Cl.: H01L 31/078

(54) **PROCÉDÉ DE CARACTÉRISATION D'UNE CELLULE SOLAIRE DANS DES CONDITIONS SIMILAIRES À CELLES D'UN DISPOSITIF SOLAIRE À ARCHITECTURE TANDEM**

(30) Priorité: 30.09.2020 FR 2009990
(71) Demandeur: Commissariat à l'énergie atomique et aux énergies alternatives, 75015 Paris (FR)
(72) Inventeur: PUAUD, Apolline, 38054 Grenoble Cedex 09 (FR); MUNOZ, Maria-Delfina, 38054 Grenoble Cedex 09 (FR); SAPORI, Daniel, 38054 Grenoble Cedex 09 (FR)
(74) Mandataire: Brevalex

(57) **Abrégé**

Procédé comprenant les étapes successives suivantes :
a) choisir un dispositif tandem comprenant :
- une première cellule solaire de type pérovskite comprenant : une couche d'un premier type de conductivité, une couche active, une couche d'un deuxième type de conductivité,
- un matériau de jonction, et
- une deuxième cellule solaire comprenant au moins une deuxième couche active.

b) fabriquer une structure test (200) comprenant :
- une première cellule solaire (110) et un matériau de jonction (130) identiques à ceux du dispositif tandem (100), et
- un empilement (180) du deuxième type de conductivité comprenant deux couches (181, 183) du deuxième type de conductivité séparées par une couche active (182) identique à la deuxième couche active du dispositif tandem.

c) caractériser la première cellule solaire (110) de la structure test (200), par exemple en mesurant la courbe I-V de la première cellule solaire (110).

## Description

### DOMAINE TECHNIQUE

La présente invention se rapporte au domaine des dispositifs photovoltaïques, en particulier des cellules photovoltaïques de type tandem pérovskite sur hétérojonction de silicium à 2 ou 3 terminaux.

L'invention concerne un procédé de caractérisation d'une cellule solaire supérieure (i.e. positionnée en face avant) dans des conditions similaires à celle d'un dispositif solaire à architecture tandem.

L'invention concerne également une structure test permettant de mettre en œuvre un tel procédé de caractérisation.

L'invention est particulièrement intéressante puisqu'elle permet une caractérisation électrique quasi directe de la cellule supérieure, dans des conditions représentatives de l'intégration en architecture tandem.

L'invention conduit à une meilleure compréhension et/ou optimisation des cellules solaires tandem.

### ÉTAT DE LA TECHNIQUE ANTÉRIEURE

Les cellules solaires permettent de convertir une partie du domaine spectral du rayonnement solaire en énergie. Pour augmenter le rendement de cette conversion, il est possible de fabriquer un dispositif à architecture tandem comprenant deux sous-ensembles (i.e. une cellule supérieure et une cellule inférieure), absorbant dans des domaines spectraux différents, empilés l'un sur l'autre selon un schéma NIP/NIP ou PIN/PIN, et séparés par une jonction (dite jonction de recombinaison).

Les performances de ces dispositifs tandem dépendent de plusieurs paramètres, et notamment du choix des matériaux, des techniques de dépôt et des interfaces.

Cependant, l'intégration de la cellule supérieure en architecture tandem à 2 ou 3 terminaux rend très complexe voire impossible la caractérisation des performances photovoltaïques de la cellule supérieure seule, indépendamment de la réponse de la cellule inférieure. En effet, les caractéristiques des différentes couches formant la cellule supérieure sont grandement dépendantes du substrat sur lequel elles sont déposées ainsi que des étapes de fabrication mises en œuvre, notamment dans le cas des cellules à base de pérovskite.

Actuellement, la caractérisation électrique d'une cellule supérieure à base de pérovskite déjà intégrée dans un dispositif tandem est limitée à la mesure de l'efficacité quantique externe EQE (« External Quantum Efficiency »), comme, par exemple, montré dans l'article de Hou et al. (« Efficient tandem solar cells with solution-processed perovskite on textured crystalline silicon », Science 367, 1135-1140 (2020)). Cette mesure permet d'accéder à la densité de courant de court-circuit de la cellule à base de pérovskite mais elle ne permet pas de retracer une courbe I-V de cette cellule seule. Il est uniquement possible d'obtenir une courbe I-V de la structure tandem dans son ensemble.

En conséquence, l'influence de la cellule inférieure (matériaux, épaisseurs, texturation de surface) et/ou de la jonction sur les performances de la cellule supérieure est difficile à étudier.

### EXPOSE DE L'INVENTION

Un but de la présente invention est de proposer un procédé permettant de caractériser les propriétés structurelles et/ou électriques (notamment les courbes I-V) d'une cellule supérieure dans des conditions de fonctionnement similaire à celle d'un dispositif à architecture tandem.

Pour cela, la présente invention propose un procédé de caractérisation d'une cellule solaire dans des conditions similaires à celles d'un dispositif tandem, le procédé comprenant les étapes successives suivantes :
a) choisir un dispositif tandem d'intérêt comprenant depuis la face avant vers la face arrière :
   - une première cellule solaire comprenant depuis la face avant : une première couche d'un premier type de conductivité, une première couche active, une première couche d'un deuxième type de conductivité opposé au premier type de conductivité,
   - un matériau de jonction, et
   - une deuxième cellule solaire comprenant une deuxième couche du premier type de conductivité, une deuxième couche active et une deuxième couche du deuxième type de conductivité,
b) fabriquer une structure test permettant de caractériser la première cellule solaire dans des conditions similaires à celles du dispositif tandem, la structure test comprenant depuis la face avant vers la face arrière :
   - une première cellule solaire identique à la première cellule solaire du dispositif tandem,
   - un matériau de jonction identique au matériau de jonction du dispositif tandem, et
   - un empilement du deuxième type de conductivité comprenant, de préférence, deux couches du deuxième type de conductivité, séparées par une couche active identique à la couche active de la deuxième cellule solaire,
c) caractériser la première cellule solaire de la structure test, par exemple en mesurant la courbe I-V de la première cellule solaire.

L'invention se distingue fondamentalement de l'art antérieur par l'utilisation d'une structure test comprenant une partie (la première cellule solaire et le matériau de jonction) identique à celle du dispositif tandem et, à la place de la deuxième cellule solaire, un empilement du deuxième type de conductivité.

Par empilement du deuxième type de conductivité, on entend que l'empilement ne comprend pas de couches du premier type de conductivité. Il comprend des couches du second type de conductivité et une couche active identique à celle de la deuxième cellule solaire du dispositif tandem, et/ou des couches non dopées.

L'empilement du deuxième type de conductivité forme une résistance calculable.

Le type de conductivité dépend de la configuration de la cellule supérieure : le deuxième type de conductivité est N si la cellule supérieure est de type NIP et le deuxième type de conductivité est P si la cellule supérieure est de type PIN.

La structure test présentée permet ainsi d'étudier la cellule supérieure fabriquée dans les mêmes conditions qu'en cellule tandem. Ceci est particulièrement intéressant dans le cas des cellules solaires pérovskites dont les conditions d'obtention (dépôt par voie liquide) sont très sensibles à la nature des couches inférieures.

La structure test proposée permet, notamment, une caractérisation électrique quasi directe de la cellule supérieure, dans des conditions représentatives de l'intégration en tandem.

Avantageusement, la première cellule solaire est une cellule solaire de type pérovskite.

Avantageusement, la deuxième cellule solaire est une cellule solaire à hétérojonction de silicium (SHJ).

Selon différentes variantes avantageuses de réalisation, la première cellule solaire et la deuxième cellule solaire sont choisies parmi l'un des couples de cellules solaires suivants : pérovskite/pérovskite, pérovskite/SHJ, pérovskite/CIGS, pérovksite/Topcon et GaAsP/SHJ.

Selon une première variante de réalisation, le premier type de conductivité est une conductivité de type P (i.e. il s'agit d'une structure tandem de type NIP-NIP).

Selon une deuxième variante de réalisation, le premier type de conductivité est une conductivité de type N (i.e. il s'agit d'une structure tandem de type PIN-PIN).

Avantageusement, on répète les étapes b) et c) avec des matériaux de jonction de différentes natures et/ou de différentes épaisseurs.

Avantageusement, le dispositif tandem comprend 2, 3 ou 4 terminaux. Encore plus préférentiellement, le dispositif tandem comporte 2 ou 3 terminaux.

Il est ainsi possible d'avoir un dispositif tandem de type NIP à deux terminaux, un dispositif de type NIP à trois terminaux, un dispositif tandem de type NIP à quatre terminaux, un dispositif de type PIN à deux terminaux, un dispositif tandem de type PIN à trois terminaux ou un dispositif tandem de type PIN à quatre terminaux.

L'invention concerne également une structure test comprenant depuis la face avant vers la face arrière :
- une première cellule solaire comprenant depuis la face avant : une première couche d'un premier type de conductivité, une première couche active, une première couche d'un deuxième type de conductivité opposé au premier type de conductivité,
- un matériau de jonction, et
- un empilement du deuxième type de conductivité comprenant, de préférence, au moins deux couches du deuxième type de conductivité séparées par une deuxième couche active.

Avantageusement, la première couche active comprend au moins un matériau pérovskite et la deuxième couche active est en silicium cristallin.

D'autres caractéristiques et avantages de l'invention ressortiront du complément de description qui suit.

Il va de soi que ce complément de description n'est donné qu'à titre d'illustration de l'objet de l'invention et ne doit en aucun cas être interprété comme une limitation de cet objet.

### BREVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
La figure 1A représente, de manière schématique et en coupe, un dispositif tandem PIN-PIN à deux terminaux.
La figure 1B représente, de manière schématique et en coupe, un dispositif tandem PIN-PIN à trois terminaux.
La figure 1C représente, de manière schématique et en coupe, une structure test permettant de caractériser les cellules solaires supérieures des dispositifs tandem représentés aux figures 1A et 1B, selon un mode de réalisation particulier de l'invention.
Les figures 2A, 2B, 2C représentent les circuits électriques équivalents simplifiés à une diode des dispositifs tandem et de la structure test représentées, respectivement, sur les figures 1A, 1B et 1C.
Les figures 3A, 3B, 3C représentent, de manière schématique et en coupe, une structure-test à différentes étapes de son procédé de fabrication, selon un mode de réalisation particulier de l'invention.
La figure 3D représente le circuit électrique équivalent de la structure test représentée sur la figure 3C.
La figure 4 est un graphique représentant les franges de diffraction, obtenues par diffraction des rayons X, pour deux couches de pérovskites, obtenues à partir de la même formulation et avec le même procédé de dépôt, l'une correspondant à la couche de pérovskite de la structure représentée sur la figure 3B, et l'autre correspondant à une référence (simple jonction sur verre).
La figure 5 est un graphique représentant les indices optiques (n et k) de deux couches de pérovskites, obtenues à partir de la même formulation et avec le même procédé de dépôt, l'une correspondant à la couche de pérovskite de la structure représentée sur la figure 3B, et l'autre correspondant à une référence (simple jonction sur verre).
Les figures 6A et 6B sont des graphiques représentant les courbes I-V de trois cellules supérieures d'une structure test telle que représentée à la figure 3C, respectivement sous lumière et dans le noir.
La figure 7 est un graphique représentant l'EQE en fonction de la longueur d'onde, obtenu à partir de la structure représentée sur la figure 3B.
Les figures 8A, 8B, 8C sont des clichés obtenus au microscope électronique à balayage d'une couche de pérovskite, provenant de la structure représentée sur la figure 3B.
La figure 8D est un cliché obtenu au microscope confocal d'une couche de pérovskite, provenant de la structure représentée sur la figure 3B.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

En outre, dans la description ci-après, des termes qui dépendent de l'orientation, tels que « dessus » / « supérieure », «dessous » / « inférieure », etc. d'une structure s'appliquent en considérant que le dispositif tandem et la structure test sont orientés de la façon illustrée sur les figures.

### EXPOSE DETAILLE DE MODES DE REALISATION PARTICULIERS

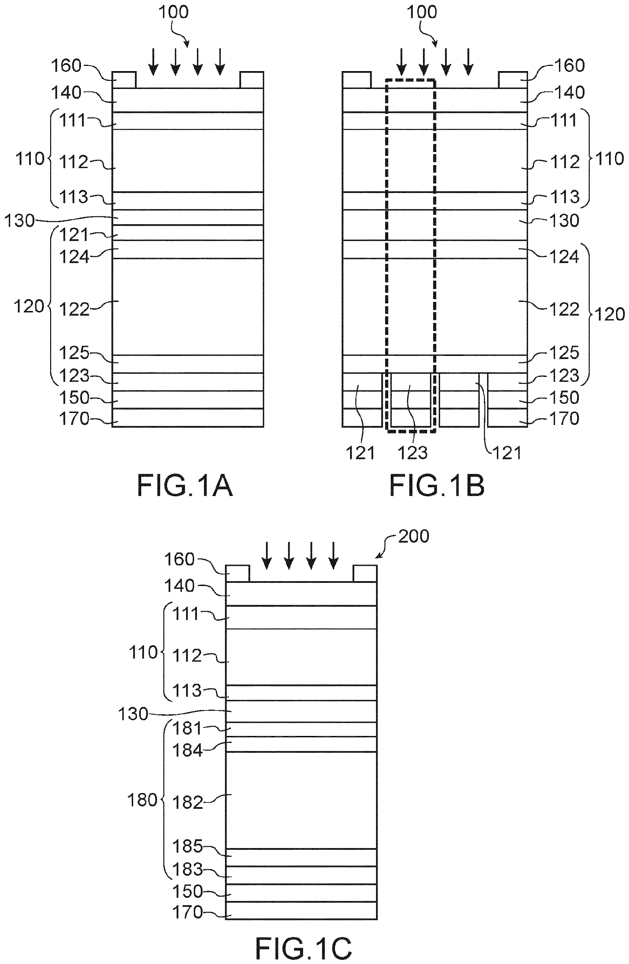

Le procédé de caractérisation d'une cellule supérieure dans des conditions similaires à celle d'un dispositif tandem comprend les étapes suivantes :
i) choisir un dispositif tandem 100 d'intérêt à étudier comme, par exemple, un dispositif tel que représenté sur les figures 1A et 1B comprenant :
   - une première cellule 110 (ou cellule supérieure pour « top cell ») positionnée en face avant du dispositif,
   - une deuxième cellule 120 (ou cellule inférieure pour « bottom cell ») positionnée en face arrière du dispositif,
   - un matériau de jonction 130, formé d'une ou plusieurs couches, séparant la première cellule 110 de la deuxième cellule 120.
ii) fabriquer une structure test 200 (aussi appelé véhicule test) permettant de caractériser la cellule supérieure 110 dans des conditions d'intégration similaires à celle du dispositif tandem 100, la structure test comprenant (figure 1C) :
   - la même première cellule 110 et le même matériau de jonction 130 que le dispositif tandem d'intérêt 100, et
   - un empilement 180 de type N si la cellule supérieure est une cellule NIP (i.e. la couche de la cellule supérieure en contact avec le matériau de jonction est de type N) ou un empilement 180 de type P si la cellule supérieure est une cellule PIN (i.e. la couche de la cellule supérieure en contact avec le matériau de jonction est de type P).
iii) caractériser la structure test 200 et plus particulièrement la cellule supérieure 110 de la structure test 200.
iv) éventuellement, fabriquer une autre structure test en modifiant un des éléments de la structure test utilisée à l'étape iii) afin de déterminer l'influence de cet élément sur les propriétés morphologiques ou (photo)électriques de la cellule supérieure ; par exemple, il est possible de modifier la nature et/ou l'épaisseur du matériau de jonction 130 ou d'une des couches de la cellule supérieure.

On appelle face avant, la face destinée à recevoir le rayonnement lumineux (représentée par des flèches sur les figures 1A et 1B).

### Dispositif tandem 100 d'intérêt choisi à l'étape i) :

La première cellule 110 du dispositif tandem 100 comprend, au moins, depuis la face avant vers le matériau de jonction 130 : une première couche d'un premier type de conductivité 111, une première couche active 112, une première couche d'un deuxième type de conductivité 113.

La première cellule 110 peut être une cellule pérovskite, organique ou multi-jonction (MJSC) à base de matériaux III-V (AlGaAs, GalnP, GaAs). La première cellule peut également être en silicium amorphe.

A titre illustratif, une première cellule 110 pérovskite de type PIN comprend depuis la face avant vers le matériau de jonction 130 :
- une couche semi-conductrice de type N 111 dite « couche de transport d'électrons » (ou EIL pour « Electron Injection Layer » ou ETL pour « Electron Transport Layer ») ou couche de type N,
- une couche active 112 contenant au moins un matériau pérovskite
- une couche semi-conductrice de type P 113 dite « couche de transport de trous » (ou HTL pour « Hole transporting Layer ») ou couche de type P.

La couche de type N 111 est, par exemple, un oxyde métallique tel que l'oxyde de zinc (ZnO), de l'oxyde de zinc dopé à l'aluminium aussi appelé AZO (ZnO :Al), l'oxyde de titane (TiO₂) ou l'oxyde d'étain (SnO₂).

Le matériau pérovskite a de formule générale ABX₃ avec A représentant un ou plusieurs cations, tel qu'un ammonium, comme le méthylammonium ou le formamidinium, ou encore un cation métallique, comme le césium ou le rubidium ; B représentant un métal comme Pb, Sn, Ag ou un de leurs mélanges; et X représentant un ou plusieurs anions halogénures.

Plus particulièrement, le matériau pérovskite peut avoir pour formule particulière H₂NCHNH₂PbX₃, CsₓFA₁₋ₓPb(l_{1-y}Br_{y})₃ avec x < 0,17 ; 0 < y < 1 et FA représentant le cation formamidinium ou CH₃NH₃PbX₃ avec X un halogène. Il peut s'agir par exemple de iodure de plomb méthylammonium CH₃NH₃Pbl₃.

La couche de type P 113 est, par exemple, un composé organique comme du Poly(3,4-éthylenedioxythiophène) Polystyrene sulfonate (PEDOT:PSS), du [poly(bis 4-phényl}{2,4,6-trimethylphényl}amine)] (PTAA), du [Poly(*N,N'*-bis(4-butylphényl)-*N,N'*-bis(phényl)-benzidine] (Poly-TPD), du 2,2',7,7'-Tétrakis[N,N-di(4-méthoxyphényl)amino]-9,9'-spirobifluorène (spiro-OMeTAD), du N4,N4'-bis(4-(6-((3-éthyloxetan-3-yl)méthoxy)hexyl)phényl)-N4,N4'-diphényl-[1,1'-biphényl]-4,4'-diamine (OTPD) ou du pyrène, ou encore un oxyde métallique tel qu'un oxyde de molybdène, un oxyde de vanadium ou un oxyde de tungstène.

Dans le cas d'un dispositif à structure NIP, les positions des couches de type P et N sont inversées.

Le matériau de jonction 130 séparant la cellule supérieure 110 de la cellule inférieure 120 joue le rôle de « jonction de recombinaison » en architecture tandem car il sert à contacter électriquement les deux sous-cellules 110, 120 et permet aux charges (aux trous de la cellule inférieure et aux électrons de la cellule supérieure en structure NIP) de se recombiner. Le matériau de jonction 130 peut comprendre une ou plusieurs couches. Par exemple, on pourra utiliser une couche d'un TCO (ITO, IZO, AZO...) ou une double couche tunnel en silicium, par exemple : (n+)nc-Si :H/(p+)nc-Si :H.

La deuxième cellule solaire 120 comprend au moins une deuxième couche du premier type de conductivité 121, une deuxième couche active 122 et une deuxième couche du deuxième type de conductivité 123.

La position des différentes couches de la deuxième cellule solaire 120 dépend du nombre de terminaux du dispositif tandem 100.

Pour un dispositif tandem 100 à deux terminaux (figure 1A), la deuxième cellule 120 comprend successivement depuis le matériau de jonction 130 vers la face arrière :
- une couche du premier type de conductivité 121,
- une couche active 122, et
- une couche du deuxième type de conductivité 123.

Pour un dispositif tandem 100 à deux terminaux (figure 1B), la deuxième cellule 120 comprend successivement depuis le matériau de jonction 130 vers la face arrière :
- une couche active 122, et
- disposées de manière adjacente, une couche du premier type de conductivité 121 et une couche du deuxième type de conductivité 122.

Le dispositif est un dispositif à contact arrière interdigité (IBC pour « Interdigitated Back Contact »).

Selon une autre variante non représentée, le dispositif tandem 100 pourrait également être un dispositif à 4 terminaux.

La deuxième cellule 120 peut être une cellule en pérovskite, en CIGS (Cu(In,Ga)Se₂), ou encore il peut s'agir d'une cellule à base de silicium, par exemple, à homojonction ou à hétérojonction de silicium (HET-Si ou SHJ pour « Silicon HeteroJunction solar cell »), de type PERC (« Passivated Emitter and Rear Contact ») ou TopCon (« Tunnel Oxide Passivated Contact ») ou encore une cellule PERT type N avec double diffusion de phosphore. D'une manière générale, pour la deuxième cellule en silicium, on pourra choisir toutes les cellules à contacts passivés, basse température (SHJ) mais aussi haute température (type TOPCON, POLO... avec du poly-Si à la place du a-Si).

A titre illustratif, dans le cas d'une cellule inférieure 120 à hétérojonction de silicium de type PIN ou à émetteur inversé en configuration à 2 terminaux, la cellule inférieure 120 peut comprendre depuis le matériau de jonction 130 vers la face arrière (figure 1A):
- une couche de silicium amorphe dopé N 121,
- une couche de silicium amorphe intrinsèque 124,
- une couche active de silicium monocristallin 122,
- une couche de silicium amorphe intrinsèque 125,
- une couche de silicium amorphe dopé P 123.

Dans le cas d'un dispositif à structure NIP ou émetteur standard, les positions des couches de de type N et de type P sont inversées.

Dans le cas d'une cellule inférieure 120 à hétérojonction de silicium en configuration de type PIN à 3 terminaux, la cellule inférieure 120 peut comprendre depuis le matériau de jonction 130 vers la face arrière (figure 1B) :
- une couche de silicium amorphe intrinsèque 124,
- une couche active de silicium monocristallin 122,
- une couche de silicium amorphe intrinsèque 125,
- une couche de silicium amorphe dopé P 123 adjacente à une couche de silicium amorphe dopé N 121.

Le dispositif tandem 100 peut comprendre également :
- une première électrode 140 (électrode supérieure) disposée sur la face avant du dispositif ; la première électrode est électriquement conductrice et optiquement transparente, de manière à laisser passer les photons jusqu'à la couche active 112 de la cellule supérieure 110. Cette électrode 140 peut être en oxyde transparent conducteur, typiquement de l'oxyde d'indium-étain (ITO) ou de l'oxyde de zinc dopé à l'aluminium (ZnO :Al), ou encore elle peut être formée d'un polymère transparent conducteur comprenant des nanofils d'argent par exemple,
- une deuxième électrode 150 (électrode inférieure) disposée en face arrière ; l'électrode inférieure 150 peut, avantageusement, être opaque ou de transparence limitée, par exemple, en métal (par exemple, en argent, en or, en chrome ou en aluminium),
- des reprises de contact 160 en face avant et des reprises de contact 170 en face arrière ; les reprises de contact peuvent être par exemple en argent.

La face avant et la face arrière peuvent être indépendamment l'une de l'autre polie ou texturée.

### Structure test 200 :

La structure test 200 fabriquée à l'étape ii) pour caractériser le dispositif 100 de cellules solaires va maintenant être décrit plus en détail.

Une même structure test 200 permet de simuler l'intégration en architecture tandem à deux terminaux (figure 1A) ou à trois terminaux (figure 1B)

La structure test 200 comprend depuis la face avant vers la face arrière au moins (figure 1C) :
- une première cellule solaire 110 à caractériser, identique à la première cellule solaire du dispositif tandem d'intérêt 100,
- un matériau de jonction 130, identique au matériau de jonction du dispositif tandem 100, et
- un empilement 180 comprenant au moins deux couches 181, 183 du deuxième type de conductivité séparées par une couche active 182 identique à celle de la deuxième cellule solaire 120 du dispositif tandem 100.

La structure test 200 comprend également, comme le dispositif tandem 100, une première électrode 140 disposée sur la face avant de la structure test, une deuxième électrode 150 disposée en face arrière de la structure test ainsi que des reprises de contact 160, 170 en face avant et arrière, par exemple en argent.

Une telle structure test permet de caractériser facilement les porteurs photogénérés par la première cellule solaire 110 dans une configuration tandem puisque l'empilement 180 (ici de type P) sous le matériau de jonction 130 se comporte comme un substrat de type P et forme ainsi une résistance calculable.

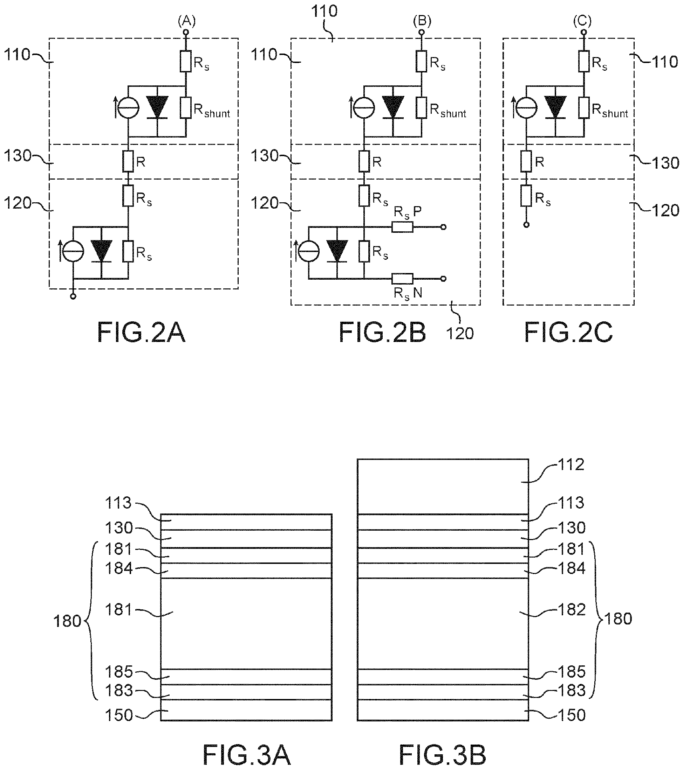

Les figures 2A, 2B et 2C représentent, respectivement, les circuits électriques équivalents du dispositif tandem 100 à deux terminaux représenté sur la figure 1A, du dispositif tandem 100 à 3 terminaux représenté sur la figure 1B et de la structure test 200 correspondante représentée sur la figure 1C. Le circuit électrique équivalent de la structure test est simplifié par rapport à ceux des dispositifs tandem classiques.

A titre illustratif, pour tester une cellule solaire pérovskite dans des conditions similaires à celles d'un dispositif à structure PIN à 2 ou 3 terminaux comprenant des cellules tandem pérovskite sur hétérojonction de silicium, la structure test comprend depuis la face avant vers la face arrière :
- un contact en face avant 160,
- une première électrode 140,
- une première cellule 110 comprenant :
- une couche semi-conductrice de type N 111 dite « couche de transport d'électrons » (ou EIL pour « Electron Injection Layer » ou ETL pour « Electron Transport Layer ») ou couche de type N,
- une couche active 112 contenant au moins un matériau pérovskite,
- une couche semi-conductrice de type P 113 dite « couche de transport de trous » (ou HTL pour « Hole transporting Layer ») ou couche de type P,
- un matériau de jonction 130,
- un empilement de type P 180 comprenant depuis le matériau de jonction 130 vers la face arrière : une couche de silicium amorphe dopé P 181, une couche de silicium amorphe intrinsèque 184, une couche active de silicium monocristallin 182, une couche de silicium amorphe intrinsèque 185, une couche de silicium amorphe dopé P 153,
- une deuxième électrode 150, et
- un contact en face arrière 170.

### Caractérisations :

Lors de l'étape iii), on caractérise la structure test 200. Il peut s'agir de caractérisations structurelles et/ou électriques et/ou photométriques, par exemple choisies parmi : courbes I-V, ellipsométrie, diffraction des rayons X, efficacité quantique externe (EQE), microscopie électronique à balayage, microscopie confocale.

### Optimisation / amélioration du dispositif tandem 100 :

Lors de l'étape iv), on peut fabriquer une autre structure test en modifiant un ou plusieurs éléments de la structure test afin de déterminer leurs impacts sur la morphologie, la cristallinité, et/ou les performances (photo)électriques (courbes I-V notamment) de la cellule supérieure.

Une telle structure test permet d'optimiser à la fois les propriétés physiques et électriques du matériau de jonction 130 et/ou de la cellule supérieure 110.

Des LEDs à base de pérovskite pourraient également être caractérisées en utilisant le même type de structure.

### Exemples illustratifs et non limitatifs d'un mode de réalisation :

Dans cet exemple, une structure test 200 pour caractériser une cellule de type NIP a été fabriquée puis caractérisée.

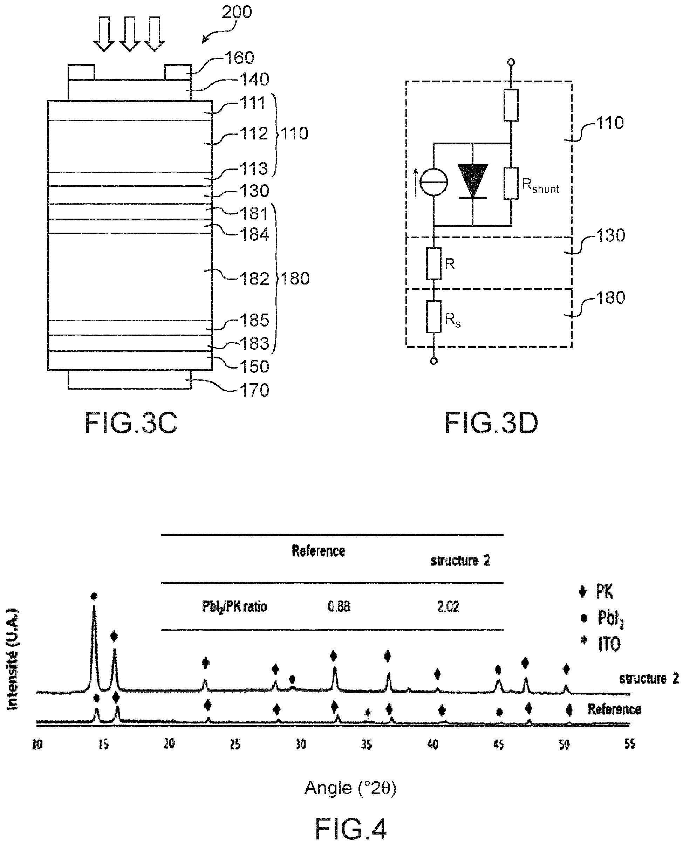

La fabrication de la cellule test a été réalisée selon les étapes suivantes (figures 3A, 3B et 3C) :
a) Nettoyage des substrats (« wafers ») Topsil CMP 4 pouces, avec HF HCl last, destinés à former la couche active 182 de l'empilement 180
b) Dépôt par PECVD (« plasma enhanced chemical vapor deposition ») des couches de silicium amorphe non dopé (i) 184, 185 et dopés de type (n) 181, 183 (excès d'électrons). Épaisseur totale des couches (i) et (n) : 15 nm
c) Dépôt par PVD (pulvérisation cathodique) de deux couches 130, 150 d'oxide d'indium-étain (ITO) : 70 nm sur la face arrière et 12 nm sur la face avant
d) Découpe au laser des substrats 4" en carrés de 5 x 5 cm
e) Traitement UV ozone sur la face avant couverte par la couche 130 d'ITO de recombinaison : 30 min
f) Formation de la couche 113 de SnO₂ en déposant par dépôt à la tournette (« spin-coating ») une solution aqueuse de nanoparticules de SnO₂. La couche est ensuite recuite 1 min à 80°C sur plaque chauffante.
g) Dépôt de la couche pérovskite 112 par dépôt à la tournette. Le matériau pérovskite peut avoir pour formule Cs_{0.05}FA_{0.95}Pb(l_{0.83}Br_{0.17})₃ ou CsₓFA₁₋ₓPb(l_{1-y}Br_{y})₃ avec x < 0,17 ; 0 < y < 1 et FA représentant le cation formamidinium. Recuit 1 heure à 100°C.
h) Dépôt de la couche PTAA 111 par dépôt à la tournette. Pas de recuit.
i) Dépôt par PVD (pulvérisation cathodique) de la couche d'ITO 140 en face avant avec utilisation de masques pour limiter la surface à 3 x 3 cm: 180nm à température ambiante (i.e. environ 20°C),
j) Évaporation des contacts 160 face avant Au : 200nm.
k) Métallisation 170 de la face arrière par évaporation d'Argent : 200nm.

La couche d'ITO 130 de 12nm déposé lors de l'étape c) est utilisée comme « jonction de recombinaison » en architecture tandem : elle sert à contacter électriquement les deux sous-cellules et permet aux charges (aux trous de la cellule inférieure et aux électrons de la cellule supérieure en structure NIP) de se recombiner. Avantageusement, la couche d'ITO 130 de recombinaison est déposée avec le moins d'O₂ possible pour maximiser la concentration de porteurs et ainsi favoriser les recombinaisons. Avantageusement, il est préférable de déposer la couche d'ITO la plus fine en premier (i.e. avant de déposer la couche d'ITO 150 de la face arrière) afin de ne pas dégrader la durée de vie des porteurs de la couche 130 d'ITO la plus fine lors du budget thermique de la couche 150 d'ITO la plus épaisse.

Avantageusement, l'étape i) est réalisée sans préchauffage pour préserver les couches thermosensibles.

Les étapes f), g) et h) sont, avantageusement, réalisées en boîte à gants.

Les épaisseurs des différentes couches sont répertoriées dans le tableau suivant. L'épaisseur correspond à l'épaisseur de consigne Les notations X et Y correspondent respectivement aux épaisseurs minimale et maximale peuvent être obtenues à partir de l'épaisseur de consigne.

| | **Épaisseur (nm)** | **X (nm)** | **Y (nm)** |
|---|---|---|---|
| **Electrode 140 en ITO face avant** | 180 | 160 | 210 |
| **Couche PTAA 111** | 25 | 5 | 60 |
| **Couche 112 de Cs0.05FA0.95Pb(l0.83Br0.17)3** | 250 | 50 | 600 |
| **Couche 130 de SnO₂** | 40 | 10 | 70 |
| **Film113 d'ITO rec.** | 12 | 5 | 20 |
| **Couche 184 de a-Si:H (n)** | 8 | 3 | 12 |
| **Couche 181 de a-Si:H (i)** | 6 | 3 | 12 |
| **Couche active 182 de c-Si** | 280 000 | 260 000 | 300 000 |
| **Couche 185 de a-Si:H (i)** | 6 | 3 | 12 |
| **Couche 183 de a-Si:H (n)** | 8 | 3 | 12 |
| **Couche 150 d'ITO** | 70 | 60 | 80 |

La surface active de la structure test finale est de 9 cm².

La structure test 200 a été caractérisée à différentes étapes de son procédé de fabrication :
- structure 1 représentée sur la figure 3A : structure obtenue après réalisation des étapes a) à f),
- structure 2 représentée sur la figure 3B : structure obtenue après réalisation des étapes a) à g),
- structure 3 représentée sur la figure 3C : structure test obtenue après réalisation des étapes a) à k) - le circuit électrique équivalent de la structure 3 est représenté sur la figure 3D.

Les techniques de caractérisation utilisées sur les différentes structures sont répertoriées dans le tableau suivant :

| **Caractérisations** | **Structure 1** | **Structure 2** | **Structure 3** |
|---|---|---|---|
| **I-V (sous éclairement et dans l'obscurité)** | | | X |
| **Ellipsométrie** | X | X | |
| **EQE** | | | X |
| **XRD** | X | X | |
| **MEB** | X | X | |
| **Microscopie Optique Confocale** | X | X | |

Les résultats obtenus sur différentes structures test (structure 3) sont répertoriés dans le tableau suivant :

| **Dispositif** | **1^{ère} structure test** | **2^{ème} structure test** | **3^{ème} structure test** |
|---|---|---|---|
| **J_sc [mA/m²]** | -13.25 | -13.98 | -14.06 |
| **V_oc [V]** | 0.9529 | 0.9097 | 0.9635 |
| **FF [%]** | 57.68 | 56.16 | 55.46 |
| **Efficacité [%]** | 7.28 | 7.14 | 7.52 |
| **I_sc [A]** | -0.12 | -0.13 | -0.13 |
| **J_mpp [mA/cm²]** | -11.44 | -11.57 | -11.82 |
| **V_mpp [V]** | 0.64 | 0.62 | 0.64 |
| **Jsc corrigée [mA/m²] (sans ombrage)** | -16.11 | -17.00 | -17.10 |
| **Efficacité corrigée [%] (sans ombrage)** | 8.85 | 8.68 | 9.14 |

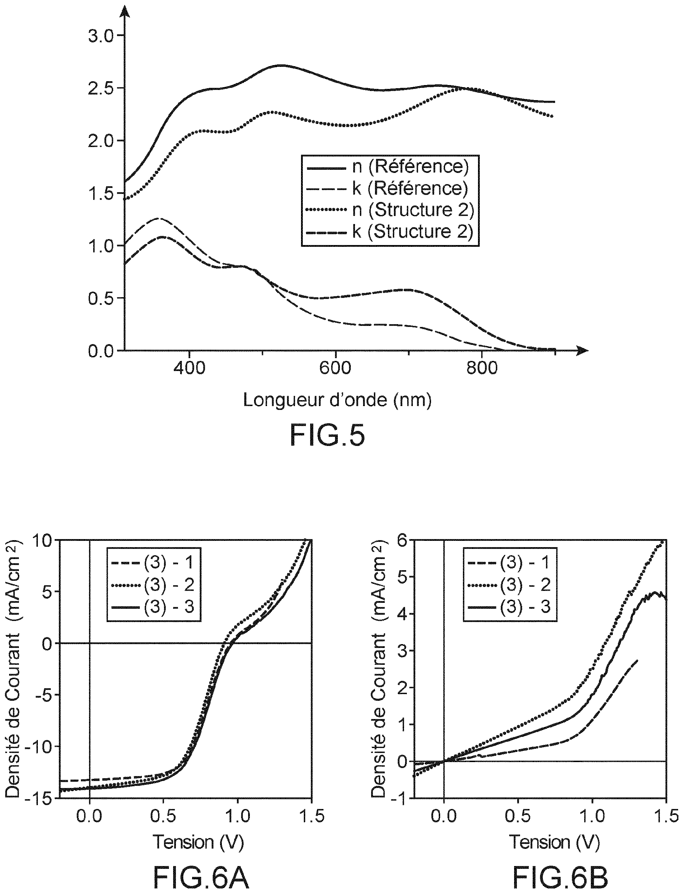

La couche de pérovskite 112 de la structure 2 a été caractérisée par diffraction des rayons X (figure 4) et mesure des indices optiques (figure 5). Ces données ont été comparées avec une couche de pérovskite déposée sur un empilement comprenant un support en verre, une couche d'ITO 210nm et une couche ETL identique. Il apparaît clairement que la cristallisation de la couche 112 de pérovskite et ses propriétés optiques sont fortement influencées par le substrat sur lequel la couche de pérovskite est déposée.

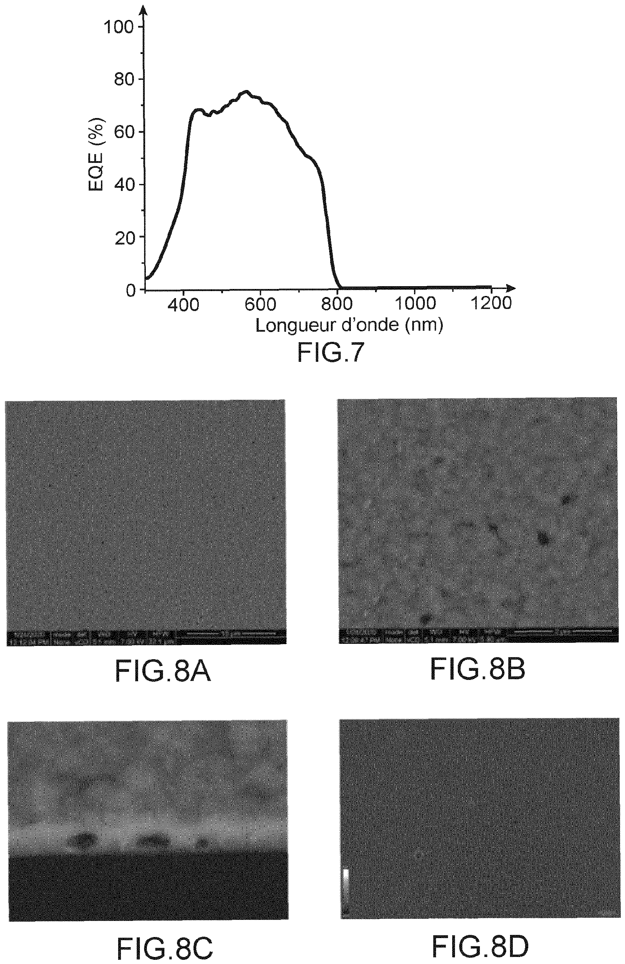

Les mesures I-V sous éclairement (figure 6A) et dans l'obscurité (Figure 6B) montrent que la structure de test 200 fonctionne. Ceci est confirmé par les mesures d'efficacité quantique externe (ou EQE) (Fig. 7). Avec la structure de test présentée (Fig. 3C), la courbe I-V de la cellule supérieure 110 à base de pérovskite en série avec les résistances de jonction et de l'empilement 180 N a été mesurée. De plus, il a été observé sur les courbes I-V sous lumière les mêmes tendances que dans le tandem à 2 terminaux. Ces tendances ne sont pas observées dans les cellules solaires pérovskite à jonction unique.

Il a été observé au MEB (figures 8A, B et C) et en microscopie optique confocale figure 8d) quelques trous dans la couche 112 de pérovskite. Ces défauts peuvent être responsables d'une diminution de la résistance shunt dans les cellules solaires en tandem.

Des structures 1 fabriquées en déposant une couche 113 de SnO₂ (structure 1) déposée sur différentes couches 130 de TCO ont également été étudiées. En fonction de la nature de la couche 130 de TCO, on observe des impacts différents sur à la fois la couche 113 de SnO₂ et la couche 112 de pérovskite ainsi que sur les courbes I-V.

Avec la structure de test 200 présentée, il est possible de modifier plusieurs éléments de la cellule supérieure 120 en pérovskite afin d'améliorer les résistances de shunt responsables de fortes limitations dans les cellules solaires en tandem. La possibilité de tester électriquement la cellule supérieure 120 de pérovskite et non la cellule tandem dans son entier est rendue possible grâce à la structure de test 200 présentée. Il est ainsi possible d'améliorer les cellules solaires tandem à 2 ou 3 terminaux.

Une structure test comprenant une cellule supérieure de silicium amorphe a également été réalisée avec succès.

## Revendications

1. Procédé de caractérisation d'une cellule solaire dans des conditions similaires à celles d'un dispositif tandem, le procédé comprenant les étapes successives suivantes :
a) choisir un dispositif tandem (100) comprenant depuis la face avant vers la face arrière :
- une première cellule solaire (110) de type pérovskite comprenant depuis la face avant : une première couche d'un premier type de conductivité (111), une première couche active (112), une première couche d'un deuxième type de conductivité (113),
- un matériau de jonction (130), et
- une deuxième cellule solaire (120) comprenant une deuxième couche du premier type de conductivité (121), une deuxième couche active (122) et une deuxième couche du deuxième type de conductivité (123),
b) fabriquer une structure test (200) comprenant depuis la face avant vers la face arrière :
- une première cellule solaire (110) identique à la première cellule solaire du dispositif tandem (100),
- un matériau de jonction (130) identique au matériau de jonction du dispositif tandem (100), et
- un empilement (180) du deuxième type de conductivité comprenant deux couches (181, 183) du deuxième type de conductivité séparées par une couche active (182) identique à la deuxième couche active du dispositif tandem (100),
c) caractériser la première cellule solaire (110) de la structure test (200), par exemple en mesurant la courbe I-V de la première cellule solaire (110).

2. Procédé selon la revendication 1, caractérisé en ce la deuxième cellule solaire (120) est une cellule solaire à hétérojonction de silicium.

3. Procédé selon l'une quelconque des revendications précédentes, **caractérisé en ce que** la première cellule solaire (110) et la deuxième cellule solaire (120) sont choisies parmi l'un des couples de cellules solaires suivants : pérovskite/pérovskite, pérovskite/SHJ, pérovskite/CIGS et GaAsP/SHJ.

4. Procédé selon l'une des revendications 1 à 3, **caractérisé en ce que** le premier type de conductivité est une conductivité de type P.

5. Procédé selon l'une des revendications 1 à 3, **caractérisé en ce que** le premier type de conductivité est une conductivité de type N.

6. Procédé selon l'une quelconque des revendications précédentes, **caractérisé en ce que** l'on répète les étapes b) et c) avec des matériaux de jonction (130) de différentes natures et/ou de différentes épaisseurs.

7. Procédé selon l'une quelconque des revendications précédentes, **caractérisé en ce que** le dispositif tandem (100) comprend 2, 3 ou 4 terminaux.

8. Structure test (200) comprenant depuis la face avant vers la face arrière :
- une première cellule solaire (110) de type pérovskite comprenant depuis la face avant : une première couche d'un premier type de conductivité (111), une première couche active (112), une première couche d'un deuxième type de conductivité (113),
- un matériau de jonction (130), et
- un empilement (180) du deuxième type de conductivité comprenant deux couches (181, 183) du deuxième type de conductivité séparées par une deuxième couche active (182).

9. Structure test selon la revendication 8, **caractérisée en ce que** la deuxième couche active (182) est en silicium cristallin.
